# EUROPÄISCHE PATENTSCHRIFT

(11) **EP 0 470 332 B1**
(45) Veröffentlichungstag und Bekanntmachung des Hinweises auf die Patenterteilung: **20.09.1995**
(21) Anmeldenummer: 91106480.6
(22) Anmeldetag: 23.04.1991
(51) Int. Cl.: F16C 13/00

(54) **Walze zum Führen und Strecken von Bändern und/oder Folienbahnen**
Roll member for guiding and stretching strips and/or foil webs
Rouleau pour guider et étirer des bandes et/ou des feuilles continues

(30) Priorität: 09.08.1990 DE 4025232
(43) Veröffentlichungstag der Anmeldung: 12.02.1992
(73) Patentinhaber: LEYBOLD AKTIENGESELLSCHAFT, D-63450 Hanau (DE)
(72) Erfinder: Kleyer, Siegfried, W-6452 Hainburg (DE)

(56) Entgegenhaltungen:
- DE-A- 2 201 844
- DE-A- 3 338 965
- DE-U- 8 610 958
- DE-U- 8 907 282
- FR-A- 2 210 240
- FR-A- 2 416 377
- GB-A- 875 737
- US-A- 4 674 667

## Beschreibung

Die Erfindung betrifft eine Walze zum Führen und Strecken von Bändern und/oder Folienbahnen für Wickeleinrichtungen, vorzugsweise für Vorrichtungen zum kontinuierlichen Bedampfen oder Besputtern von Kunststoffbändern und -bahnen im Vakuum, wobei eine Vielzahl von auf der Walzenachse hintereinanderliegend angeordnete Außenbuchsen gleicher Konfiguration vorgesehen sind, die berührungsfrei im Abstand zueinander gehalten sind und das Folienband oder die Folienbahn die Außenbuchsen teilweise umschlingt und dabei mit Vorspannung an Partien der Zylindermantelflächen der Außenbuchsen anliegt.

Bekannt ist eine Streck- und Stauchwalze für Bogen oder Bahnen aus biegsamem Werkstoff (DE-C- 892 286), die zwischen den Endabschnitten eine gebogene Strecke aufweist und die - mit der gebogenen Achse der Walze in beliebigen Ebenen einstellbar - festgeklemmt werden können. Derartige Streck- und Stauchwalzen sind mit einem elastischen Schlauch aus textilem Werkstoff versehen, der über die einzelnen Walzenabschnitte gezogen ist und so für einen kontinuierlichen Lauf der Walzenabschnitte sorgt. Diese bekannte Walze hat unter anderem den Nachteil, daß sie sich erfahrungsgemäß stark elektrostatisch auflädt, was bei einer Wickeleinrichtung für eine Sputtervorrichtung nicht akzeptabel ist.

Bekannt ist weiterhin eine Breitstreckwalze, insbesondere für die Behandlung von Textil-, Papier- oder Kunststoffbahnen (DE-U-8 907 282), bestehend aus einer starren gebogenen Achse und auf dieser Achse in geringem Abstand drehbeweglich angeordneten Rohrabschnitten, die auf flexiblen Stützringen lagern und über axial zwischen den Stützringen angeordnete, auf der Achse fixierbare Wälzlager auf der Achse abgestützt sind, wobei zum Antrieb der Rohrabschnitte an einem Ende der Breitstreckwalze unter Zwischenschaltung von Übertragungsmitteln ein Elektromotor angeordnet ist, wobei in Verlängerung der Achse eine von dem Elektromotor antreibbare Kardanwelle angeordnet ist, deren Drehmoment über eine am Ende der Achse angeordnete Traghülse auf die Rohrabschnitte zentrisch übertragbar ist. Bei dieser Breitstreckwalze sind die Rohrabschnitte auf den Wälzlagern so angeordnet, daß ihre Längsachsen jeweils die Längsachse der gebogenen Achse tangieren. Ein wesentlicher Nachteil dieser Breitstreckwalze besteht darin, daß die starre Achse nur um ein sehr geringes Maß gebogen werden kann, da die Stützringe den Versatz der Rohrabschnitte nur in engen Grenzen ausgleichen kann.

Der vorliegenden Erfindung liegt nun die Aufgabe zugrunde, eine Walze des in Frage stehenden Typs zu schaffen, die preiswert in der Herstellung ist, deren Gleichlauf von besonderer Präzision ist, die geringe Geräusche erzeugt, die hohe Drehzahlen bei Vermeidung eines besonderen Schmiersystems ermöglicht und die auch unter den Bedingungen eines Hochvakuums ihre Eigenschaften behält, also beispielsweise keine Teile enthält, die aus Werkstoffen bestehen, die zum Ausgasen und damit zum Brüchigwerden neigen.

Diese Aufgabe wird gemäß der Erfindung dadurch gelöst, daß jeder Außenbuchse ein Axial-Zylinderrollenlager zugeordnet ist, dessen Innenring jeweils unmittelbar auf der gebogenen Walzenachse angeordnet ist und das gegen axiales Verschieben gegenüber der jeweiligen Außenbuchse durch einen in diese eingepreßten Ring gesichert ist, wobei die Innenbohrung jeder Außenbuchse eine sich radial nach innen zu erstreckende Stufe oder Schulter aufweist, die jeweils zusammen mit dem eingepreßten Ring einen Käfig für das zugeordnete Axial-Zylinderrollenlager bildet.

Vorzugsweise sind die einer Außenbuchse zugeordnete Wälzkörper gegenüber den Wälzkörpern der jeweils benachbarten Außenbuchsen durch auf die Achse aufgeschobene Abstandsbuchsen im Abstand zueinander gehalten.

Zweckmäßigerweise sind die an den Wälzkörpern zweier benachbarter Außenbuchsen anliegenden Ringe so bemessen, daß die einander zugekehrten Stirnflächen dieser Außenbuchsen stets einen Mindestabstand voneinander aufweisen.

Bei einer alternativen Ausführungsform rollt jeder jeweils einer Außenbuchse zugeordnete Wälzkörper auf einer Innenbuchse ab, die auf die gerade Achse aufgeschoben ist, wobei mindestens eine der Innenbuchsen eine die Lauffläche der Wälzkörper bildende zylindrische Außenfläche aufweist, deren Rotationsachse in einem spitzen Winkel zur Längsachse der zylindrischen Innenbohrung der Innenbuchse verläuft.

Mit Vorteil weist die Innenbuchse eine sich radial nach außen zu erstreckende Stufe oder Schulter auf, an der der Innenring des jeweils zugeordneten Wälzkörpers anliegt, dessen Außenring durch zwei in die Außenbuchse eingepreßte Buchsen an einer axialen Verschiebung relativ zur Außenbuchse gehindert ist.

Um sicherzustellen, daß die Innenbuchsen mit ihren geneigten Außenmantelflächen sich nicht relativ gegeneinander verdrehen, sind diese an ihren einander zugekehrten Stirnflächen mit Verzahnungen, Vorsprünge oder Verzapfungen versehen, die zusammen eine (formschlüssige) drehfeste Verbindung der jeweils benachbarten Innenbuchsen bilden und damit relative Drehbewegungen der Innenbuchsen gegeneinander ausschließen.

Die Erfindung läßt die verschiedensten Ausführungsmöglichkeiten zu; zwei davon sind in den anhängenden Zeichnungen prinzipiell dargestellt, und zwar zeigen:
- Fig. 1: den Teillängsschnitt durch eine Walze mit einer gebogenen Achse,
- Fig. 2: den Teillängssschnitt durch eine Walze mit einer geraden Achse und mit auf dieser angeordneten Innenbuchsen und den auf diesen Innenbuchsen abrollenden Wälzkörpern und
- Fig. 3 & 4: rein schematische Darstellungen der Funktionen der Walze nach Figur 2.

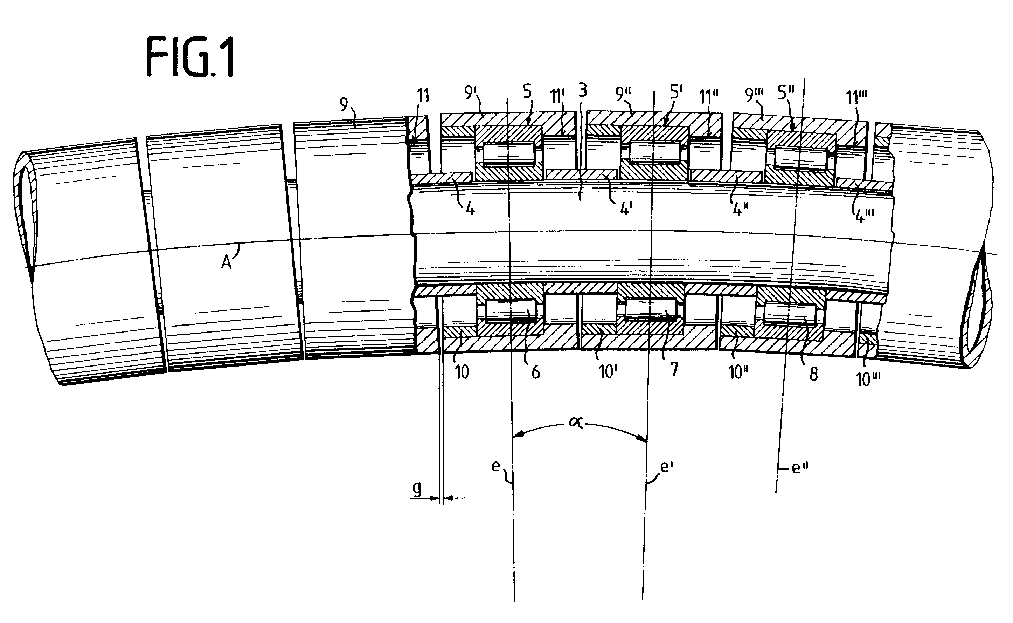

Die Walze zum Führen bzw. Strecken von Bandwickeln gemäß Figur 1 besteht im wesentlichen aus einer gebogenen Walzenachse 3, deren beide Enden im (nicht näher dargestellten) Maschinengestell gehalten sind und einer Vielzahl von auf der Walzenachse 3 hintereinanderliegend angeordneten zylindrischen Abstandsbuchsen 4, 4', ..., die jeweils durch Gruppen oder Sätze 5, 5', 5'', ... von Wälzkörpern 6, 7, 8 auf Abstand gehalten sind, wobei die einzelnen Wälzkörpersätze 5, 5', 5'', ... jeweils von Außenbuchsen 9, 9', 9'' umschlossen sind, so daß sich eine Vielzahl von nebeneinanderliegend angeordneten Axial-Zylinderrollenlager ergeben, deren sich jeweils quer zur Rotationsachse A durch den Wälzkörpersatz erstreckenden mittigen Ebenen e, e', e'', ... jeweils unter einem spitzen Winkel α, α', α'', ... geneigt zueinander verlaufen. In die Außenbuchsen 9, 9', 9'', ... sind jeweils Ringe oder Buchsen 10, 10', 10'', ... eingepreßt, die dafür Sorge tragen, daß die von den Außenbuchsen 9, 9', 9'', ... umschlossenen Wälzkörper 6, 6', ... in ihrer Bewegung in Richtung der Längsachse A begrenzt sind. Die Außenbuchsen 9, 9', 9'', ... weisen dazu an ihren Innenflächen außerdem jeweils einen Flansch oder eine Schulter 11, 11', 11'',... auf, an denen jeweils die entsprechenden Wälzkörper 6, 7, 8 der Wälzkörpersätze 5, 5', ... anliegen.

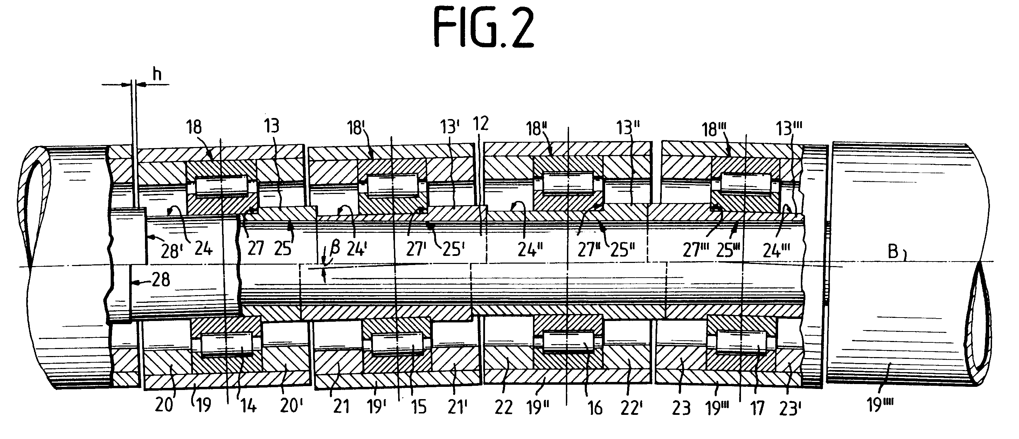

Bei der Walzenausführung gemäß Figur 2 ist die in das Maschinengestell eingespannte Achse 12 gerade ausgebildet und im Gegensatz zu derjenigen nach Figur 1 mit einer Vielzahl von hintereinanderliegend angeordneten Innenbuchsen 13, 13', 13'', ... versehen, auf denen jeweils die Wälzkörper 14, 15, 16, 17 der Wälzkörpersätze 18, 18', ... abrollen. Alle Wälzkörpersätze 18, 18', 18'', ... sind von hohlzylindrischen Außenbuchsen 19, 19', 19'', ... umschlossen, wobei die Wälzkörper 14, 15, 16, 17 gegen ein axiales Verschieben mit Hilfe von in die Außenbuchsen 19, 19', 19'', ... eingesetzte hohlzylindrische Buchsen 20, 20' bzw. 21, 21' bzw. 22, 22', ... gesichert sind. Die Innenbuchsen 13, 13', 13'', ... weisen jeweils eine zylindrische Innenbohrung 25, 25''', ... und eine jeweils zu dieser Innenbohrung in einem Winkel β schräg verlaufende zylindrische Außenmantelfläche 24, 24', 24''' auf. Bei der Ausführungsform gemäß Figur 2 ist jedoch eine der Innenbuchsen 13'' mit einer zylindrischen Mantelfläche 24'' versehen, deren Rotationsachse mit derjenigen der Innenbohrung 25'' zusammenfällt; außerdem ist die schräge zylindrische Mantelfläche 24''' der Innenbuchse 13''' auf der rechten Seite der Innenbuchse 13''' vorgesehen, während die schrägen Mantelflächen 24, 24' der beiden linken Innenbuchsen 13, 13' auf der linken Seite der Walze angeordnet sind, so daß die über die Außenbuchsen 19, 19', 19'', ... abrollende Folienbahn 26 faltenfrei bzw. glatt gezogen bzw. gestreckt wird.

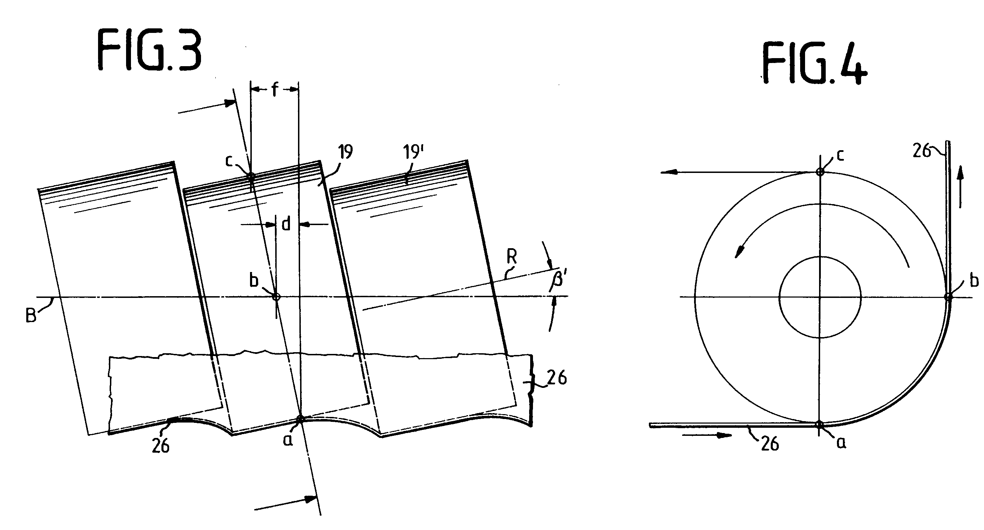

Das Funktionsprinzip der Walze gemäß Figur 2 ist in den Figuren 3 und 4 rein schematisch näher gezeigt. In diesem Falle sind die Außenbuchsen 19, 19', 19'' der besseren Übersichtlichkeit wegen gegenüber der Längsachse B um die Winkel β' weitaus stärker geneigt dargestellt als in der Zeichnung gemäß Figur 2. Die Folienbahn 26 berührt beispielsweise am Orte a die Außenbuchse 19 und verläßt diese wieder am Orte b bei einer Umschlingung eines Viertels der Außenbuchse 19.

Bei einer Umschlingung einer Hälfte des Umfangs der Außenbuchse 19 hebt die Folienbahn 26 im Orte c von der Außenbuchse 19 ab. Infolge der Schrägstellung der Rotationsachse R zur Längsachse B um den Winkel β' wandert dabei der angenommene Berührungsort a zwischen Folienbahn 26 und der Außenbuchse 19 um die Strecke d nach links bis zum Ort b, wenn die Folienbahn 26 die Außenbuchse 19 zu einem Viertel umschlingt (= optimaler Umschlingungswinkel), und um die Strecke f, wenn als Abhebeort c (= maximaler Umschlingungswinkel) gewählt wurde.

Um zu verhindern, daß sich die einzelnen, auf die Achse 12 aufgeschobenen Innenbuchsen 13, 13', ... gegeneinander verdrehen, sind ihre Stirnflächen jeweils mit Verzapfungen oder Verzahnungen 28, 28', ... versehen.

## Patentansprüche

1. Walze zum Führen und Strecken von Bändern und/oder Folienbahnen (25) für Wickeleinrichtungen, vorzugsweise für Vorrichtungen zum kontinuierlichen Bedampfen oder Besputtern von Kunststoffbändern und -bahnen im Vakuum, wobei eine Vielzahl von auf der Walzenachse (3) hintereinanderliegend angeordnete Außenbuchsen (9, 9') gleicher Konfiguration vorgesehen sind, die berührungsfrei im Abstand (g) zueinander gehalten sind und das Folienband oder die Folienbahn (25) die Außenbuchsen (9, 9') teilweise umschlingt und dabei mit Vorspannung an Partien der Zylindermantelflächen der Außenbuchsen (9, 9', ...) anliegt, **dadurch gekennzeichnet**, daß jeder Außenbuchse (9, 9', ...) ein Axial-Zylinderrollenlager (5, 5', ...) zugeordnet ist, dessen Innenring jeweils unmittelbar auf der gebogenen Walzenachse (3) angeordnet ist und das gegen axiales Verschieben gegenüber der jeweiligen Außenbuchse (9, 9', ...) durch einen in diese eingepreßten Ring (10, 10', ...) gesichert ist, wobei die Innenbohrung jeder Außenbuchse (9, 9', ...) eine sich radial nach innen zu erstreckende Stufe oder Schulter (11, 11', ...) aufweist, die jeweils zusammen mit dem eingepreßten Ring (10, 10', ...) einen Käfig für das zugeordnete Axial-Zylinderrollenlager (5, 5', ...) bildet.

2. Walze nach Anspruch 1, **dadurch gekennzeichnet**, daß die einer Außenbuchse (9, 9', ...) zugeordneten Wälzkörper gegenüber den Wälzkörpern (6, 7, 8) der jeweils benachbarten Außenbuchsen durch auf die Achse (3) aufgeschobene Abstandsbuchsen (4, 4', ...) im Abstand zueinander gehalten sind.

3. Walze nach den Ansprüchen 1 und 2, **dadurch gekennzeichnet**, daß die an den Wälzkörpern (6, 7, 8) zweier benachbarter Außenbuchsen (9, 9', ...) anliegenden Ringe (4, 4', ...) so bemessen sind, daß die einander zugekehrten Stirnflächen dieser Außenbuchsen (9, 9', ...) stets einen Mindestabstand (g) voneinander aufweisen.

4. Walze zum Führen und Strecken von Bändern und/oder Folienbahnen (25) für Wickeleinrichtungen, vorzugsweise für Vorrichtungen zum kontinuierlichen Bedampfen oder Besputtern von Kunststoffbändern und -bahnen im Vakuum, wobei eine Vielzahl von auf der Walzenachse (12) hintereinanderliegend angeordneten Außenbuchsen (19, 19', ...) gleicher Konfiguration vorgesehen sind, die berührungsfrei im Abstand (h) zueinander gehalten sind und das Folienband oder die Folienbahn (25) die Außenbuchsen (19, 19', ...) teilweise umschlingt und dabei mit Vorspannung an Partien der Zylindermantelflächen der Außenbuchsen (19, 19', ...) anliegt, **dadurch gekennzeichnet**, daß jeder jeweils einer Außenbuchse (19, 19', ...) zugeordnete Wälzkörper (14, 15, 16, 17) auf einer Innenbuchse (13, 13', ...) abrollt, die auf die gerade Achse (12) aufgeschoben ist, wobei mindestens eine der Innenbuchsen (13, 13', ...) eine die Lauffläche der Wälzkörper (14, 15, 16, 17) bildende zylindrische Außenfläche (24, 24', ...) aufweist, deren Rotationsachse (R) in einem spitzen Winkel (β) zur Längsachse (B) der zylindrischen Innenbohrung (25, 25', ...) der Innenbuchse (13, 13', ...) verläuft.

5. Walze nach Anspruch 4, **dadurch gekennzeichnet**, daß die Innenbuchse (13, 13', ...) eine sich radial nach außen zu erstreckende Stufe oder Schulter (27, 27', ...) aufweist, an der der Innenring des jeweils zugeordneten Wälzkörpers (14, 15, 16, 17) anliegt, dessen Außenring durch zwei in die Außenbuchse (19, 19', ...) eingepreßte Buchsen (20, 20'; 21, 21'; 22, 22'; 23, 23') an einer axialen Verschiebung relativ zur Außenbuchse (19, 19', ...) gehindert ist.

6. Walze nach Anspruch 5, **dadurch gekennzeichnet**, daß die auf die gerade Achse (12) aufgeschobenen Innenbuchsen (13, 13', ...) an ihren jeweils einander zugekehrten Stirnflächen Verzahnungen, Vorsprünge oder Verzapfungen (28, 28', ...) aufweisen, die zusammen eine (formschlüssige) drehfeste Verbindung der jeweils benachbarten Innenbuchsen (13, 13', ...) bilden und damit relative Drehbewegungen der Innenbuchsen (13, 13', ...) gegeneinander ausschließen.

## Claims

1. Roll member for guiding and stretching strips and/or foil webs (26) for winding devices, preferably for apparatuses for the continuous vapour-deposition or sputtering of plastic strips and webs in vacuo, a plurality of external bushes (9, 9') of identical configuration being provided disposed successively on the roll member axle (3), which are held at the distance (g) from one another without contact and around which the foil strip or foil web (26) is partially wrapped and in the process is applied with initial tension against portions of the cylindrical lateral surfaces of the external bushes (9, 9', ...), **characterized in that** associated with each external bush (9, 9', ...) is a cylindrical-roller thrust bearing (5, 5', ...), whose inner ring is in each case disposed directly on the curved roll member axle (3) and which is locked against axial displacement relative to the respective external bush (9, 9', ...) by means of a ring (10, 10', ...) pressed into the external bush, the inner bore of each external bush (9, 9', ...) having a radially inward-extending step or shoulder (11, 11', ...) which, together with the impressed ring (10, 10', ...), forms a cage for the associated cylindrical-roller thrust bearing (5, 5', ...).

2. Roll member according to claim 1, **characterized in that** the rolling bodies associated with an external bush (9, 9', ...) are kept at a distance from the rolling bodies (6, 7, 8) of the adjacent external bushes by means of distance bushes (4, 4', ...) which are slipped onto the axle (3).

3. Roll member according to claims 1 and 2, **characterized in that** the rings (4, 4', ...) resting against the rolling bodies (6, 7, 8) of two adjacent external bushes (9, 9', ...) are so dimensioned that the opposing end faces of said external bushes (9, 9', ...) are always a minimum distance (g) apart from one another.

4. Roll member for guiding and stretching strips and/or foil webs (25) for winding devices, preferably for apparatuses for the continuous vapour-deposition or sputtering of plastic strips and webs in vacuo, a plurality of external bushes (19, 19', ...) of identical configuration being provided disposed successively on the roll member axle (12), which are held at the distance (h) from one another without contact and around which the foil strip or foil web (25) is partially wrapped and in the process is applied with initial tension against portions of the cylindrical lateral surfaces of the external bushes (19, 19', ...), **characterized in that** each rolling body (14, 15, 16, 17) associated with an external bush (19, 19', ...) rolls on an internal bush (13, 13', ...) which is slipped onto the straight axle (12), at least one of the internal bushes (13, 13', ...) having a cylindrical outer surface (24, 24', ...), which forms the running surface of the rolling bodies (14, 15, 16, 17) and whose axis of rotation (R) extends at an acute angle (β) to the longitudinal axis (B) of the cylindrical inner bore (25, 25', ...) of the internal bush (13, 13', ...).

5. Roll member according to claim 4, **characterized in that** the internal bush (13, 13', ...) has a radially outward-extending step or shoulder (27, 27', ...), resting against which is the inner ring of the respective associated rolling body (14, 15, 16, 17), whose outer ring is locked against axial displacement relative to the external bush (19, 19', ...) by means of two bushes (20, 20'; 21, 21'; 22, 22'; 23, 23') pressed into the external bush (19, 19', ...).

6. Roll member according to claim 5, **characterized in that** the internal bushes (13, 13', ...) slipped onto the straight axle (12) have at their opposing end faces teeth, projections or studs (28, 28', ...), which together form a (keyed) non-rotatable connection of the respective adjacent internal bushes (13, 13', ...) and hence preclude rotational movements of the internal bushes (13, 13', ...) relative to one another.

## Revendications

1. Rouleau pour guider et étirer des bandes et/ou des feuilles en continu (25) pour des enrouleuses, de préférence pour des dispositifs de métallisation ou de dépôt par pulvérisation sur des bandes ou des feuilles en continu de matière plastique sous vide, dans lequel sont prévus une multitude de manchons extérieurs (9, 9') de même configuration agencés les uns derrière les autres sur l'axe (3) du rouleau, qui sont maintenus à distance (g) les uns des autres sans se toucher, et la bande ou la feuille en continu (25) s'enroulant en partie autour des manchons extérieurs (9, 9') et reposant ainsi avec précontrainte sur des parties des surfaces enveloppe cylindrique des manchons extérieurs (9, 9', ...), caractérisé en ce qu'à chaque manchon extérieur (9, 9', ...) est associé un palier de butée à rouleaux cylindriques (5, 5', ...) dont la bague intérieure respective est agencée directement sur l'axe (3) incurvé du rouleau et est assurée contre un déplacement axial par rapport au manchon extérieur (9, 9', ...) respectif par une bague (10, 10', ...) enfoncée dans celui-ci, l'alésage intérieur de chaque manchon extérieur présentant un gradin ou épaulement (11, 11', ...) s'étendant radialement vers l'intérieur, formant avec la bague (10, 10', ...) enfoncée une cage pour le palier de butée à rouleaux cylindriques (5, 5', ...) associé.

2. Rouleau selon la revendication 1, caractérisé en ce que les corps de roulement associés à un manchon extérieur (9, 9', ...) sont maintenus à distance les uns des autres par rapport aux corps de roulement (6, 7, 8) des manchons extérieurs voisins respectifs par des douilles d'écartement (4, 4', ...) enfilées sur l'axe (3).

3. Rouleau selon les revendications 1 et 2, caractérisé en ce que les bagues (4, 4', ...) reposant sur les corps de roulement (6, 7, 8) de deux manchons extérieurs (9, 9', ...) voisins sont dimensionnées de telle sorte que les faces frontales en vis-à-vis de ces manchons extérieurs (9, 9', ...) sont toujours à une distance (g) minimum les unes des autres.

4. Rouleau pour guider et étirer des bandes et/ou des feuilles en continu (25) pour des enrouleuses, de préférence pour des dispositifs de métallisation ou de dépôt par pulvérisation sur des bandes ou des feuilles en continu de matière plastique sous vide, dans lequel sont prévus une multitude de manchons extérieurs (19, 19') de même configuration agencés les uns derrière les autres sur l'axe (12) du rouleau, qui sont maintenus à distance (h) les uns des autres sans se toucher, et la bande ou la feuille en continu (25) s'enroulant en partie autour des manchons extérieurs (19, 19', ...) et reposant ainsi avec précontrainte sur des parties des surfaces enveloppe cylindrique des manchons extérieurs (19, 19', ...), caractérisé en ce que chaque corps de roulement (14, 15, 16, 17) associé à un manchon extérieur (19, 19', ...) roule respectivement sur un manchon intérieur (13, 13', ...) qui est enfilé sur l'axe (12) rectiligne, au moins un des manchons intérieurs (13, 13', ...) présentant une surface extérieure cylindrique formant la surface de roulement des corps de roulement (14, 15, 16, 17), dont l'axe de rotation (R) forme un angle aigu (β) par rapport à l'axe longitudinal (B) de l'alésage intérieur (25, 25', ...) cylindrique du manchon intérieur (13, 13', ...).

5. Rouleau selon la revendication 4, caractérisé en ce que le manchon intérieur (13, 13', ...) présente un gradin ou un épaulement (27, 27', ...) s'étendant radialement vers l'extérieur, sur lequel repose la bague intérieure du corps de roulement (14, 15, 16, 17) respectif associé, dont la bague extérieure est empêchée de se déplacer axialement par rapport au manchon extérieur (19, 19', ...), grâce à deux douilles (20, 20' ; 21, 21'; 22, 22' ; 23, 23') enfoncées dans le manchon extérieur (19, 19', ...).

6. Rouleau selon la revendication 5, caractérisé en ce que les manchons intérieurs (13, 13', ...) enfilés sur l'axe (12) rectiligne sont pourvus sur leurs surfaces frontales qui se font face de dentures, de saillies ou d'assemblages à tenon et mortaise (28, 28', ...) qui forment ensemble une fixation solidaire en rotation (en blocage par coopération de forme) des manchons intérieurs (13, 13', ...) voisins respectifs, excluant ainsi des mouvements de rotation relative des manchons intérieurs (13, 13', ...) les uns par rapport aux autres.
